# EUROPEAN PATENT APPLICATION

(11) **EP 2 421 032 A1**
(43) Date of publication of application: **22.02.2012**
(21) Application number: 10173320.2
(22) Date of filing: 18.08.2010
(51) Int. Cl.: H01L 21/56, H01L 23/00, H01L 21/683

(54) **Semiconductor Device Packaging Method and Semiconductor Device Package**

(71) Applicant: NXP B.V., 5656 AG Eindhoven (NL)
(72) Inventor: Groenhuis, Roelf Anco Jacob, Redhill, Surrey RH1 1DL (GB); Walczyk, Sven, Redhill, Surrey RH1 1DL (GB); Dijkstra, Paul, Redhill, Surrey RH1 1DL (GB); de Bruin, Emiel, Redhill, Surrey RH1 1DL (GB)
(74) Representative: Burton, Nick

(57) **Abstract**

Disclosed is a method of manufacturing a discrete semiconductor device package (100), the method comprising providing a discrete semiconductor device wafer (10) having a first surface and a second surface opposite to the first surface, said second surface carrying at least one bond pad for each discrete semiconductor device; applying a copper contact (20, 62) to the first surface; applying under bump metallization portion (32) to each of said bond pads; forming a copper layer portion (34, 62) on each of said under bump metallization portions; and dividing the wafer in a plurality of discrete semiconductor device packages (100). A thus obtained discrete semiconductor device package (100) and a PCB carrying such a package are also disclosed.

## Description

### FIELD OF THE INVENTION

The present invention relates to a method of packaging a discrete semiconductor device such as a diode.

The present invention further relates to a discrete semiconductor device obtained by such a method.

### BACKGROUND OF THE INVENTION

Discrete semiconductor devices such as diodes are typically provided in a package when marketed. The package protects the discrete semiconductor device from accidental damage and provides the contacts for integrating the discrete semiconductor device in a larger electronic device, e.g. by mounting the discrete semiconductor device on a printer circuit board (PCB). In the known packaging approaches, the package contacts are typically fan-outs of the contacts of the discrete semiconductor device, i.e. have a larger area, as manufacturing approaches to reproduce the small dimensions of a discrete semiconductor device at the package level in a straightforward and cost-effective manner are currently unavailable.

As a consequence of the ongoing miniaturization of semiconductor devices including discrete semiconductor devices, the corresponding package sizes have to be miniaturized as well. This, however, is not trivial, as the fan-out of the package contacts poses a lower limit of the dimensions of the package. For instance, for diode packages, it is difficult to miniaturize the package beyond dimensions of 0.6 mm x 0.3 mm x 0.3 mm. Such packages are known as 0603 packages. This lower limit is largely dictated by the dimensions of the fan-out package contacts. Hence, there exists a need for a packaging method that facilitates further miniaturization of discrete semiconductor device packages and in particular diode packages in a relatively straightforward and therefore cost-effective manner.

### SUMMARY OF THE INVENTION

The present invention seeks to provide a method of manufacturing a discrete semiconductor device package that facilitates the manufacture of packages smaller than 0603 packages.

The present invention further seeks to provide a discrete semiconductor device package obtained by such a method.

In accordance with an aspect of the present invention, there is provided a method of manufacturing a discrete semiconductor device package, the method comprising providing a discrete semiconductor device wafer having a first surface and a second surface opposite to the first surface, said second surface carrying at least one bond pad for each discrete semiconductor device; applying a copper contact to the first surface; applying under bump metallization portion to each of said bond pads; forming a copper layer portion on each of said under bump metallization portions; and dividing the wafer in a plurality of discrete semiconductor device packages.

The present invention is based on the realization that the application of under bump metallization (UBM) techniques can be used to create about a 1:1 relationship between the dimensions of a discrete semiconductor device bond pad and the package contact, thereby facilitating a reduction of the form factor of the package. It is noted that this is a novel use of UBM techniques, which have been typically used in flip-chip connection techniques.

In an embodiment, the method further comprises forming a solder resist pattern to the second surface prior to applying said under bump metallization portions, said pattern exposing the at least one bond pad for each discrete semiconductor device to avoid the UBM spreading over the device surface upon soldering. Hence, this embodiment provides insulation between the copper contact and the wafer.

In order to improve the solderability of the package contacts, the method may further comprise plating the copper contact and the respective copper layer portions, wherein the plating for instance may be selected from tin, silver, metal alloys, layer stacks such as Au provided with a Ni barrier layer (i.e. a NiAu finish), NiPdAu and so on.

The package may be formed by molding the discrete semiconductor with a protective resin. In an embodiment, this may be achieved by dicing the wafer following the step of forming a copper layer portion on each of said under bump metallization portions and prior to applying the copper contact to the first surface, adhering the second surface of the diced wafer to a copper foil; molding the resultant structure with a protective resin; partially removing the protective resin to expose the first surface of the wafer; providing the copper contact to the first surface; and dividing the wafer in the plurality of discrete semiconductor devices.

In an alternative embodiment, this may be achieved by dicing the wafer following the step of forming a copper layer portion on each of said under bump metallization portions and prior to applying the copper contact to the first surface, adhering the second surface of the diced wafer to a structured copper foil; adhering the first surface of the diced wafer to a further structured copper foil; molding the resultant structure with a protective resin; and dividing the wafer in the plurality of discrete semiconductor device packages.

In yet an alternative embodiment, this may be achieved by dicing the wafer following the adhering of the copper foil to the first surface; molding the resultant structure with a protective resin; opening the protective resin to expose each of the at least one band pads; and applying a plating base to said bond pads prior to applying under bump metallization portion; and wherein the step of dividing the wafer in a plurality of discrete semiconductor devices comprises sawing the resultant structure on a sawing tape.

This has the advantage that an optional protection coating surrounding the discrete semiconductor device is provided, thus improving the robustness of the package.

In accordance with a further aspect of the present invention, there is provided a discrete semiconductor device package obtained by an embodiment of the method of the present invention. Such a discrete semiconductor device package may be soldered to a printed circuit board having a first contact and a second contact laterally displaced to the first contact. In a preferred embodiment, the discrete semiconductor device package is mounted sideways on the printed circuit board, which inter alia has the advantage that the package has a smaller footprint and as a result of that occupies a smaller area on a PCB, or may be used with a PCB designed to receive larger packages due to the fact that the contacts of the discrete semiconductor device package are oriented on the vertical sides of the packages.

### BRIEF DESCRIPTION OF THE EMBODIMENTS

Embodiments of the invention are described in more detail and by way of non-limiting examples with reference to the accompanying drawings, wherein
FIG. 1-5 are flowcharts schematically depicting different embodiments of the method of the present invention; and
FIG. 6 schematically depicts a discrete semiconductor device package of the present invention mounted on a PCB.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

The present invention will now be described in more detail referring to discrete semiconductor device packages in general. However, it should be understood that the present invention is particularly relevant to diode packages, which may contain one or multiple diodes, which may be oriented in a matrix. The packages of the present invention may also be considered for packaging alternative active components, e.g. discrete transistors.

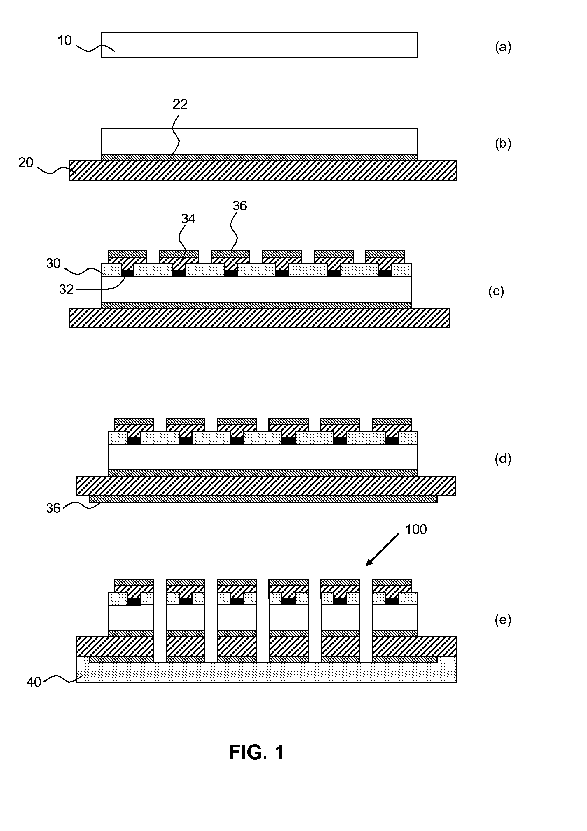

FIG. 1 depicts a first embodiment of a discrete semiconductor device packaging method of the present invention. In step (a), a wafer 10 onto which a plurality of discrete semiconductor devices have been formed in any suitable way is provided. The discrete semiconductor devices have not been shown explicitly for the sake of clarity. The wafer 10 may be of any suitable semiconductor material, such as silicon, SiGe and so on.

In step (b), the bottom surface of the wafer 10 is adhered to a copper foil 20 using a suitable conductive adhesive 22. This may be conductive glue, a conductive wafer back coating, a conductive die attach foil or any other suitable adhesive. In an alternatively embodiment, the copper foil 20 may be replaced by copper plating, in which case the adhesive 22 may be omitted. The copper plating may be applied in a pattern leaving exposed the saw lines of the wafer such that no copper plating has to cut during sawing or dicing the wafer 10, such that the wafer 10 can be sawed or diced more easily.

The method subsequently proceeds to step (c), in which the wafer 10 is provided with top plating. The wafer 10 may be provided with a solder resist pattern 30, which leaves the contact pads of the discrete semiconductor devices of the wafer 10 exposed. The material used for the solder resist pattern 30 is an electrically insulating material. Non-limiting examples of suitable materials for the solder resist pattern 30 include polyimide, BCB (butyl-chloro-benzimidazole), and so on. The exposed bond pads are provided with UBM 32, after which the top surface of the wafer 10 is provided with a pattern of copper portions 34, such that each of the UBM 32 are in conductive contact with one of the copper portions 34. Alternatively, the UBM 32 may already be present on the initial wafer (10) as provided in step (a). The solder resist pattern 30 and the pattern of copper portions 34 may be formed using any suitable lithographic process. The copper portions 34 may be provided with plating 36 to improve the solderability of the top contacts of the wafer 10. The plating 36 may be applied in any suitable manner, e.g. barrel plating, or alternatively electroless plating may be used. Suitable plating materials include tin, silver, metal alloys and layer stacks such as a niAu finish, NiPdAu and so on.

In step (d), plating 36, e.g. tin plating, is also applied to the bottom copper contact 20. In an embodiment, the copper contact 20 may be patterned before or after the tin plating step to reduce the complexity of the sawing, cutting or dicing of the wafer 10, as previously explained. In step (e), the wafer 10 is placed on a dicing tape 40 and diced into the separate packages 100, after which the dicing tape 40 may be removed and the individual packages 100 may be tested and placed in a reel for supply to the customer. The wafer 10 may be diced in any suitable manner, e.g. by sawing or by laser separation.

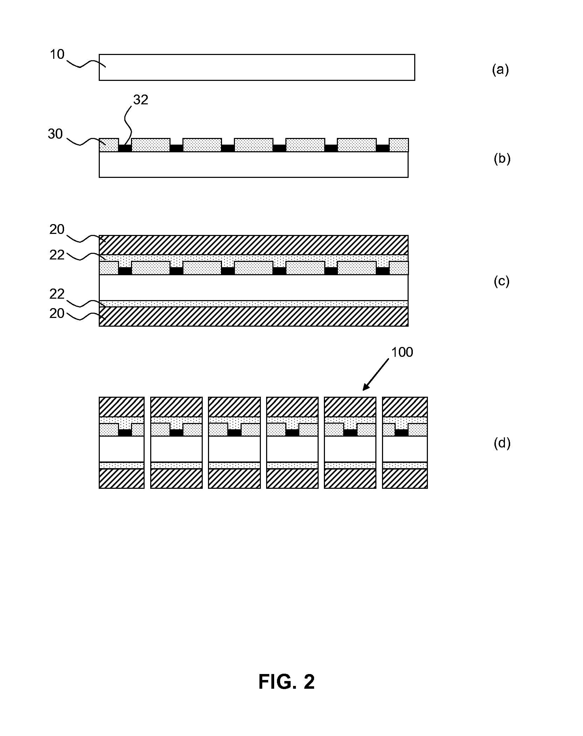

FIG. 2 depicts an alternative embodiment of a discrete semiconductor device packaging method of the present invention. In step (a), a wafer 10 onto which a plurality of discrete semiconductor devices have been formed in any suitable way is provided, as previously explained. In step (b), the solder resist pattern 30 and UBM 32 is formed as previously explained. Alternatively, the UBM 32 may already be present on the initial wafer (10) as provided in step (a). The solder resist pattern may be replaced by a pattern of any suitable electrically insulating material.

In step (c), a copper foil 20 is adhered to the bottom surface of the wafer 10 and a further copper foil 20 is adhered to the top surface of the wafer 10 using any suitable conductive adhesive 22, e.g. conductive glue, a conductive wafer back coating, a conductive die attach foil and so on. At this point, it is noted that reference marks on the wafer 10 should remain visible outside the copper foil 20 for aligning the wafer 10 in the dicing process.

Using the aforementioned reference marks for alignment purposes, the wafer 10 is subsequently diced in any suitable manner as shown in step (d), thus yielding the individual discrete semiconductor device packages 100. The copper contacts of the packages 100 may subsequently be tin plated to improve solderability, e.g. using barrel plating techniques. Alternatively, tin plating may be applied to the copper contacts prior to dicing the wafer 10.

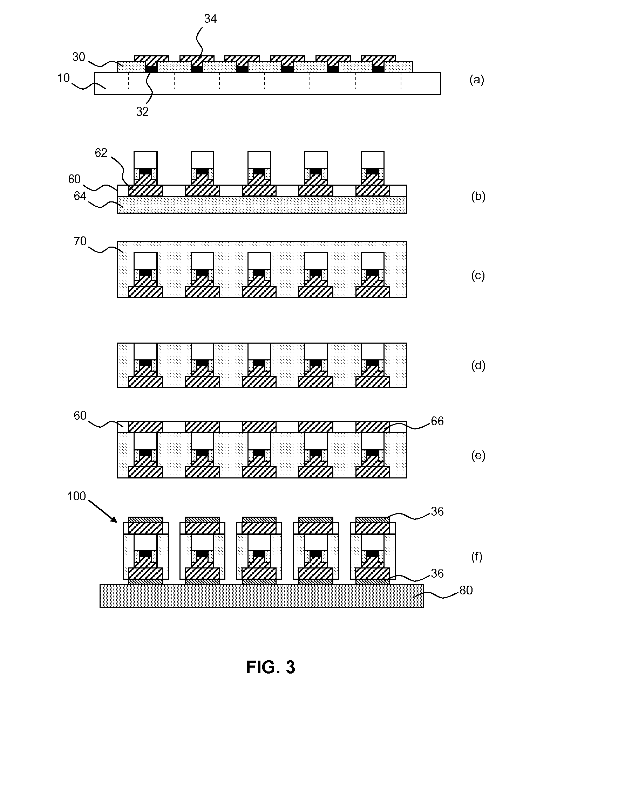

FIG. 3 depicts another alternative embodiment of a discrete semiconductor device packaging method of the present invention. In step (a), a wafer 10 onto which a plurality of discrete semiconductor devices have been formed in any suitable way is provided, as previously explained. The wafer 10 carries a solder resist pattern 30, UBM 32 on the contact pads of the discrete semiconductor devices and a pattern copper contact portions 34 in conductive contact with the UBM 32, which may be provided for instance as explained in the first embodiment of the method of the present invention. After provision of the top contacts of the wafer 10, the wafer 10 is diced as indicated by the dashed lines in step (a).

In step (b), the diced wafer 10 is flip-chipped onto a solid copper foil 20 or onto a structured copper foil 60 comprising multiple copper portions 62. 60 supported by a tape 64. Such a foil preferably has a thickness in the range of 18-100 micron, with the actual thickness selected on the basis of the desired soldering length of the bottom surface of the package when placed sideways on a carrier, as will be explained in more detail later.. The diced wafer 10 may be adhered to the structured copper foil 60 in any suitable manner, e.g. by conductive glue, a conductive wafer back coating, a conductive die attach foil and so on. This adhesive layer between the diced wafer 10 and the structured copper foil 60 is not explicitly shown for the sake of clarity. In step (c), the resultant structure is molded with a protective resin, which envelopes the discrete semiconductor devices. Any suitable protective resin, such as an epoxy molding compound may be used. After the molding step, the supporting tape 64 may be removed and the resin may be cured, after which the molding 70 is partially removed in step (d) to expose the bottom contacts of the individual discrete semiconductor devices. In step (e), copper contacts 66 are provided onto the exposed bottom contacts of the individual discrete semiconductor devices, e.g. by means of copper plating. This may be preceded by applying a plating base onto the exposed bottom contacts. The conductive plating base acts as a conductive adhesion layer for the copper plating in the plastic environment. Suitable plating base materials include TiCu, Cr, Al and so on.

The packages may be individualized in step (f) by sawing through the molding 70 using a sawing tape 80. Tin plating 36, or alternatively, electroless plating or barrel plating, may be applied to the exposed copper contacts 62 and 66 prior to or after the dicing step.

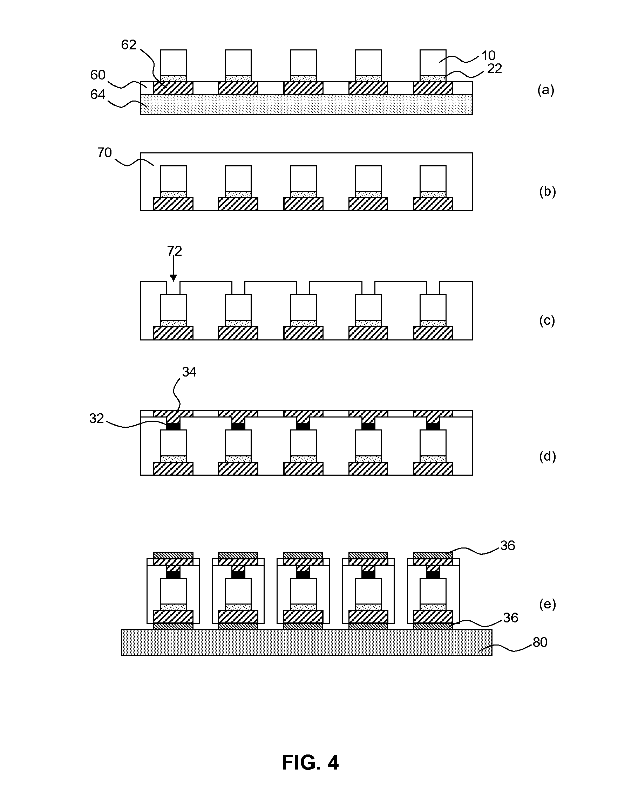

An alternative embodiment of manufacturing a molded package 100 is shown in FIG. 4. In step (a), the bottom surface of a diced wafer 10 is mounted onto a structured copper foil 60 having copper contact portions 62 and being supported by a tape 64.. The diced wafer 10 may be adhered to the structured copper foil 60 using any suitable adhesive 22, e.g. conductive glue, a conductive wafer back coating, a conductive die attach foil and so on. In step (b), the resultant structure is molded with a protective resin, which envelopes the discrete semiconductor devices. Any suitable protective resin, may be used, as has been explained previously. After the molding step, the supporting tape 64 may be removed and the resin may be cured.

In step (c), trenches 72 are formed in the molding 70, e.g. by laser drilling, to expose the bond pads of the individual discrete semiconductor devices. The structured copper foil 60 may comprise alignment aids such as alignment fiducials (not shown) to ensure that the trenches 72 are formed in the appropriate location. In step (d), UBM 32 and copper contacts 34 are formed on the exposed bond pads of the individual discrete semiconductor devices, thereby filling the trenches 72. The patterned copper contacts 34 may be formed using lithographic processes, e.g. after plating a layer of copper over the receiving surface, or alternatively using electroless or electrolytic plating.

In an alternative embodiment, the UBM 32 may already be present on the initial wafer (10) as provided in step (a) prior to applying the solder resist, which has the advantage of ensuring that the Al contacts of the IC are fully covered by the UBM 32. The copper contacts 34 may be formed after application of a plating base to allow the copper to adhere to the plastic surroundings, i.e. the molding, as previously explained. A copper layer may be patterned into the copper contacts 34 using lithography. Alternatively, the copper contacts may be formed using plating techniques, e.g. electroless or electrolytic plating.

In step (e), the packages 100 may be individualized by sawing through the molding 70 supported by a sawing tape 80. Tin plating 36, or alternatively, electroless plating or barrel plating, may be applied to the exposed copper contacts 62 and 66 prior to or after the dicing step to improve the solderability of the copper contacts.

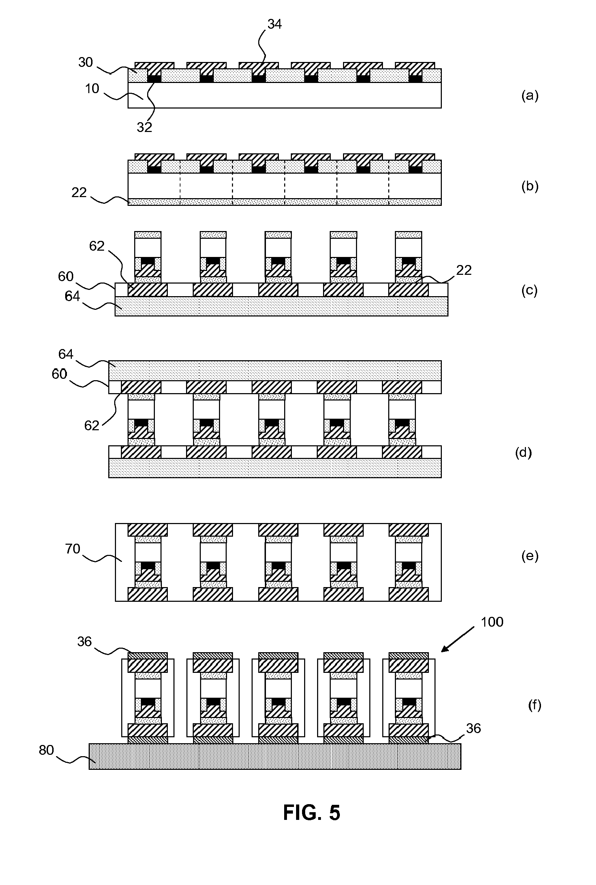

A further alternative embodiment of a method of providing a molded package 100 is shown in FIG. 5. In step (a), a wafer 10 onto which a plurality of discrete semiconductor devices have been formed in any suitable way is provided, as previously explained. The wafer 10 carries a solder resist pattern 30, UBM 32 on the contact pads of the discrete semiconductor devices and a pattern copper contact portions 34 in conductive contact with the UBM 32, which may be provided for instance as explained in the first embodiment of the method of the present invention. After provision of the top contacts of the wafer 10, the bottom surface of the wafer 10 is provided with a suitable conductive adhesive 22 as previously explained and diced as indicated by the dashed lines in step (b).

In step (c), the diced wafer 10 is flipped onto a structured copper foil 60 including copper contacts 62, using a conductive adhesive 22 to secure the diced wafer 10 onto the structured copper foil 60, which may have been placed on a supporting tape 64. In step (d), a further structured copper foil 60 including copper contacts 62 is adhered to the conductive adhesive 22 exposed on the bottom surface of the diced wafer 10, which of course is shown as the upper surface in step (d) due to the flip-chipping in step (c). The copper contacts 62 may be provided to the structured copper foil 60 using plating, and may have relatively rough surfaces to improve adhesion to the contacts.

In step (e), the resultant structure is molded using a suitable resin 70, embodiments of which have been previously given. The resultant structure is subsequently de-taped as previously explained after which the packages 100 may be individualized by sawing through the molding 70 supported by a sawing tape 80 as shown in step (f). Tin plating 36, or alternatively, electroless plating or barrel plating, may be applied to the exposed copper contacts 62 and 66 prior to or after the dicing step to improve the solderability of the copper contacts.

At this point, it is noted that the embodiments of the packaging method of the present invention facilitate the manufacture of diode packages having dimensions not exceeding 0.4 mm x 0.2 mm x 0.2 mm, i.e. 0402 packages, which is a significant reduction in size compared to the known 0603 packages. Traditionally, such packages are mounted on a PCB in a top/bottom contact orientation, with the bottom contact directly bonded to the carrier, and with the top contact being a wire bonding contact for wire bonding the top contact to the carrier. The provision of the wire bonding contact requires a minimum area which has prohibited the reduction of the package size beyond certain dimensions.

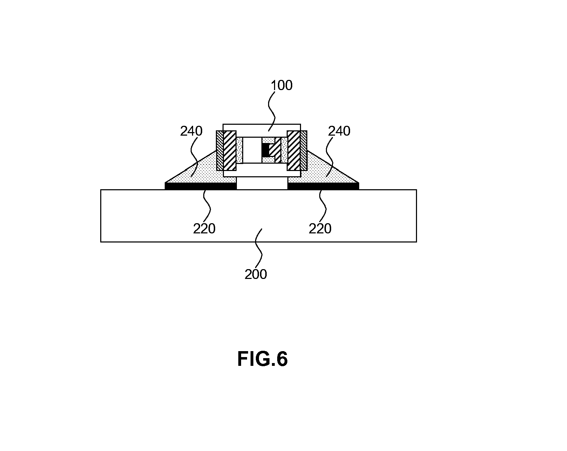

In contrast, the replacement of a wire bonding contact with solderable copper contact of the present invention facilitates the sideways mounting of such packages on a carrier such as a PCB as shown in FIG. 6. PCB 200 has contacts 220, to which the diode package 100 is soldered using soldering 240. The diode package 100 is mounted sideways, i.e. the top and bottom copper contacts of the diode package 100 are oriented vertically relative to the horizontal contacts 220 of the PCB 200, with the soldering 240 extending vertically from the contacts 220 to the copper contacts of the diode package 100. This sideways mounting of the package 100 allows the package to be used with PCBs that have been designed to receive larger form factor components, e.g. 0603 diode packages.

It should be understood that the use of the molding techniques disclosed in some of the aforementioned embodiments facilitates a further reduction of the size of the packages of the present invention, as a more compact protection of the discrete semiconductor device, e.g. diode, is achieved.

It should further be understood that in the above embodiments, structured copper foil 60, which may be a multi-carrier device, may be replaced by a copper foil 20 and vice versa. The difference between those two embodiments is that when using a copper foil 20, the copper will be exposed on the outside of the resultant package, thus providing a solderable surface on the surface of the package that is in physical contact with the carrier, i.e. on a horizontal surface, when the package is placed sideways on the carrier. This improves the strength of the solder contact between the carrier and the package. A structured copper foil 60 does not typically benefit from this advantage as the copper portions 62 are electrically insulated from each other by an insulating compound surrounding the copper portions 62, i.e. electrically insulates the copper portions from each other, which is typically exposed at the horizontal surface of the package instead. However, the use of a structured copper foil 60 supported by a tape 64 has the advantage of improved robustness and ease of handling during the manufacturing process.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of manufacturing a discrete semiconductor device package (100), the method comprising:
providing a discrete semiconductor device wafer (10) having a first surface and a second surface opposite to the first surface, said second surface carrying at least one bond pad for each discrete semiconductor device;
applying a copper contact (20, 62) to the first surface;
applying under bump metallization portion (32) to each of said bond pads;
forming a copper layer portion (34, 62) on each of said under bump metallization portions; and
dividing the wafer in a plurality of discrete semiconductor device packages (100).

2. The method of claim 1, further comprising forming a solder resist pattern (30) to the second surface prior to applying said under bump metallization portions (32), said pattern exposing the at least one bond pad for each discrete semiconductor device.

3. The method of claim 1 or 2, further comprising tin plating (36) the copper contact and the respective copper layer portions.

4. The method of any of claims 1-3, further comprising mounting the wafer on a dicing tape (40, 80) prior to dividing the wafer (10).

5. The method of any of claims 1-4, further comprising patterning the copper contact (20) prior to dividing the wafer (10).

6. The method of any of claims 1-5, wherein the copper contact (20, 62) is a copper foil, and wherein the step of applying a copper carrier to the first surface includes adhering the copper foil to the first surface.

7. The method of any of claims 1-6, wherein the step of forming a copper layer portion on each of said under bump metallization portions (32) comprises adhering a copper foil to the second surface.

8. The method of claim 6 or 7, wherein said adhering is performed using a conductive glue (22).

9. The method of any of claims 1-4, further comprising:
dicing the wafer (10) following the step of forming a copper layer portion (34) on each of said under bump metallization portions (32) and prior to applying the copper contact to the first surface,
adhering the second surface of the diced wafer to a copper foil (60);
molding the resultant structure with a protective resin (70);
partially removing the protective resin to expose the first surface of the wafer (10);
providing the copper contact (66) to the first surface; and
dividing the resultant structure into the plurality of discrete semiconductor device packages (100).

10. The method of any of claims 1-4, further comprising:
dicing the wafer (10) following the step of forming a copper layer portion (34) on each of said under bump metallization portions (32) and prior to applying the copper contact to the first surface,
adhering the second surface of the diced wafer (10) to a structured copper foil (60);
adhering the first surface of the diced wafer to a further structured copper foil (60);
molding the resultant structure with a protective resin (70); and
dividing the molded resultant structure in the plurality of discrete semiconductor device packages.

11. The method of claim 10, further comprising protecting the respective exposed surfaces of the structured copper foils with a protective tape (64) prior to said molding step and removing said tape after said molding step.

12. The method of claim 6, further comprising:
dicing the wafer (10) following the adhering of the copper foil (20) to the first surface;
molding the resultant structure with a protective resin (70);
opening the protective resin to expose each of the at least one bond pads;
and
applying a plating base to said bond pads prior to applying the under bump metallization portions (32);
and wherein the step of dividing the wafer in a plurality of discrete semiconductor device packages comprises sawing the resultant structure on a sawing tape (80).

13. A discrete semiconductor package (100) obtained by the method of any of claims 1-12.

14. A printed circuit board (200) having a first contact (220) and a second contact (220) laterally displaced to the first contact, the printed circuit board comprising the discrete semiconductor device (100) of claim 13 having a copper layer portion on its second surface soldered to the first contact and the copper contact portion on its first surface soldered to the second contact.

15. The printed circuit board of claim 14, wherein the semiconductor device package (100) is mounted sideways on the printed circuit board (200).
